# EUROPEAN PATENT SPECIFICATION

(11) **EP 0 624 914 B1**
(45) Date of publication and mention of the grant of the patent: **18.10.2000**
(21) Application number: 94303129.4
(22) Date of filing: 29.04.1994
(51) Int. Cl.: H01M 10/48, G01R 31/36, G01R 13/40

(54) **Battery with tester label and method for producing it**
Batterie mit Testeretikett und Verfahren zu seiner Herstellung
Batterie pourvue d'étiquette de contrôle et procédé de fabrication

(30) Priority: 03.05.1993 US 56158
(43) Date of publication of application: 17.11.1994
(73) Proprietor: MORGAN ADHESIVES COMPANY, Stow Ohio 44224 (US)
(72) Inventor: Weiss, Victor H., Plantation, Florida 33322 (US); Anderson, Jeffrey L., Excelsior, Minnesota 55331 (US)
(74) Representative: Waldren, Robin Michael

(56) References cited:
- EP-A- 0 450 938
- EP-A- 0 495 636
- EP-A- 0 523 901
- US-A- 4 379 816

## Description

The present invention relates to a tester device for a battery, the device forming an integral part of the label encasing the battery.

Batteries are generally stored for various periods of time before being put into use. The batteries may be stored in shops, for example, by the seller and frequently when purchased they are again stored by the buyer before being used. On occasion, batteries stored for a long period before being used will lose some of their charge. In view of this, therefore, it is desirable to have some means for testing the battery before use in order to determine if the battery has sufficient charge to operate the desired device.

Battery testers have been developed and are available. Initially, the testers developed were separate from the battery itself, but these testers could be used to measure the strength remaining in the battery. More recently battery testers that are either included in the battery package or assembled in the label secured to the battery have been developed. Testers of this type are generally used to indicate the capacity remaining in the battery.

U.S. Patent No. 4,702,564 discloses a device for testing a battery, particularly a small, portable battery, which device comprises a flexible, transparent substrate on which is deposited a narrow band of a black light absorbing material. A conductive material, which may taper outwardly in opposite directions from a central point to a pair of outer terminals, is then deposited on top of the substrate on the same side of the substrate as the absorber layer or on the opposite side of the substrate to the absorber layer. A layer of a cholesteric liquid crystal material is then deposited on the substrate either on the opposite side from the black absorber layer or over the absorber layer. The conductive material used in the device of this patent is an epoxy cement-based conductor, preferably silver, printed or painted directly on the substrate. An indicator scale is located along sections of the conductive material. To test a dry cell battery, the terminal ends of the conductive material are placed in contact with the battery terminals, causing a current to flow which, in turn, heats the conductive material. The heat generated is most intense at the central point and radiates outwardly. The heat is transferred through the thin substrate to the liquid crystal layer which results in a colour change in the liquid crystal. The traverse of the colour change along the length of the indicator scale, outwardly from the centre point, is proportional to the current or voltage output or the condition of the battery to be tested and can be read on the indicator scale which is calibrated accordingly. The tester also includes means for determining the amp-hours or life of a battery.

U.S. Patent No. 5,015,544 discloses a battery strength indicating and switch means on a battery. This device is coupled across the terminals of the battery and is provided with an indicating means to indicate the strength of the battery. In addition, the battery strength indicating means is provided with an in-line switch which can easily be depressed to complete the circuit so as to place the indicator means across the terminals of the cell and display the charge of the battery.

U.S. Patent No. 5,059,895 (corresponding to EP-A-0450938) discloses a battery voltmeter comprising:
(A) a dielectric layer;
(B) a conductive layer above or below one of the surfaces of the dielectric layer; and
(C) a temperature sensitive colour indicator layer in thermal contact with the conductive layer,
   characterised in that the conductive layer has (i) thermal insulating means under one of it surfaces and (ii) sufficient heat generating capacity to affect a change in the temperature sensitive colour indicator layer. The voltmeter of this patent can be integrated into a label and attached directly to a battery. The insulating means may be an air pocket provided between stand-offs, such as plastic strips.

U.S. Patent No. 4,835,475 discloses an apparatus for indicating the electromotive force of a dry battery which comprises:
(i) a film base;
(ii) an electrically conductive layer disposed on one side of the film base,
(iii) a protective layer disposed on the electrically conductive layer, and
(iv) a thermochromic layer disposed on the other side of the film base.

EP-A-0495636 discloses a battery tester in which a conductive tester circuit is thermally and electrically insulated from the battery housing between terminal contact ends, by one or two insulative layers disposed between the tester circuit and the battery housing.

Although testers for determining the strength remaining in a battery are available, even incorporated into the label of the battery, this art is still quite young and problems, particularly with the manufacture and expense of the devices, are encountered. Of particular significance is the fact that the prior art devices all consist of a large number of individual layers, each of which must be correctly positioned with respect to the battery itself, resulting in time-consuming manufacture and expense both to the manufacturer and to the end consumer. Furthermore, it has been found that if the conductive layer is disposed close to the housing of the battery, which is usually a metallic material, then such housing can be used as a heat sink. If this occurs, the heat generated in the conductive layer may be insufficient to be properly detected by the thermally sensitive material and may thereby provide inaccurate information as to the strength of the battery. It has been proposed to use insulation means between the base material and the conductive layer so as to overcome this problem. However, the use of an additional layer, which will increase the overall thickness of the label, increases both the difficulties of manufacture and the cost of the article.

In view of the problems associated with the prior art, there is still a need for a testing device for a battery, which device can be assembled with the battery label and which has few components, thus making it easy to assemble, preferably by an efficient automatic assembly operation, and thereby reducing the overall cost to the manufacturer and consumer.

Accordingly, in its first aspect, the present invention provides a testing device for a battery having first and second terminals, the device comprising: a non-conductive film having two openings being so arranged that the first and second terminals of the battery are exposed therethrough; insulating means located between the openings; a conductive circuit layer disposed on the non-conductive film, the conductive circuit layer being disposed over the insulating means such that the insulating means provides thermal insulation for the conductive circuit layer, the conductive circuit layer further covering the two openings in order to be able to contact the terminals of the battery therethrough; and a thermally sensitive material disposed in responsive contact with the conductive circuit layer such that heat produced by the flow of current through the conductive circuit layer on contact of the conductive circuit layer with both of the terminals results in an indication by the thermally sensitive material of the charge in the battery, characterised in that the insulating means is an expanded insulating material having a porosity of at least 10% with a plurality of openings.

In a preferred embodiment of this aspect of the invention, the testing device forms all, or part, of the label for the battery.

In a further preferred embodiment, the conductive circuit layer and the expanded insulating material are so arranged that that section of the conductive circuit layer not disposed over the openings in the non-conductive film is electrically and thermally insulated from the battery housing by the expanded insulating material.

In an alternative aspect, the present invention provides a battery including a testing device as hereinabove defined, said battery at least partially encased with a non-conductive film having a top surface and bottom surface and said film defining a first opening exposing a segment of the first terminal and a spaced apart second opening exposing a segment of the second terminal; and insulating means disposed between said first opening and said second opening; a conductive circuit layer disposed over the first opening, the second opening, and at least a portion of the insulating means so that a first segment of conductive circuit layer can be deflected through the first opening to contact the first terminal, a second segment of the conductive circuit layer can be deflected through the second opening to contact the second terminal with the remaining segment of the conductive circuit layer being electrically and thermally insulated from the terminals of the battery by the insulating means; a thermally sensitive material disposed in responsive contact with the conductive circuit layer such that when the first segment and second segment of the conductive circuit layer contact the first terminal and second terminal, respectively, a current will flow through the conductive circuit layer and heat the thermally sensitive material which will indicate the capacity of the battery characterised in that the insulating means is an expanded insulating material having a porosity of at least 10% with a plurality of openings.

The present invention further provides a method for preparing and attaching a battery testing device as defined above to a battery comprising the steps:
(a) preparing a non-conductive base film having a top surface and a bottom surface and producing in said film a first opening and a spaced apart second opening; and depositing an insulating means on said base film between said first opening and said second opening;
(b) securing a thermally sensitive material to the top surface of a conductive circuit layer and securing the bottom surface of the conductive circuit layer onto the top surface of the base film and over the first opening, the second opening and at least a portion of the insulating means such that a first segment of the conductive circuit layer can deflect into and through said first opening, the insulating means providing electrical and thermal insulation for at least a portion of the remaining conductive circuit layer between the first opening and second opening;
(c) adhering the bottom surface of the base film to the housing of a battery having a first terminal and second terminal of opposite polarity such that the first opening is positioned over the first terminal and the second opening is positioned over the second terminal so that said first segment can be deflected to contact only the first terminal and the second terminal contacts or is contactible with a second segment of the conductive circuit layer through the second opening to complete an electrical circuit between the terminals that allows current to flow through the conductive circuit layer to create heat detectable by the thermally sensitive material,
   characterised in that the insulating means is a single layer of an expanded insulating material having a porosity of at least 10% with a plurality of openings.

### Brief Description of the Drawings

The invention will now be further described with reference to the following drawings, in which:
Figure 1a is an exploded view of the various components of a test circuit label of this invention;
Figure 1b is an isometric view of another embodiment of an expanded insulating material having a plurality of openings;
Figure 2 is a plan view of a continuous sheet of label carrier containing individual test circuit devices of this invention;
Figure 3 is an isometric view of a cell employing the test circuit device of this invention; and
Figure 4 is an isometric view of a cell employing the test circuit device of this invention encased in an outer layer.

The non-conductive base film comprises two openings, one of which must, in use, be disposed over the first terminal and the other of which must, in use, be disposed over the second terminal of the battery. The precise size of these two openings is not essential to the present invention and depends on, for example, the type of battery for which the tester is destined. In particular, the openings should be of a size sufficient to allow contact between the conductive circuit layer covering said openings and the terminal of the battery. Typically, however, we have found that openings of from 0.001 square inch to 0.008 square inch (6.45 x 10⁵ µm² to 51.61 x 10⁵ µm²), preferably from 0.002 to 0.005 square inch (12.19 x 10⁵ to 32.26 x 10⁵ µm²) are suitable. Within this range, the smaller openings would be most suitable for smaller batteries, such as the AAA type cells, whereas openings towards the top end of the range would be most suitable for batteries with a larger diameter and different curvature, for example the D-size batteries.

Thus, for example, AAA size cells could have the two openings disposed over the terminals of the battery of a size with in the range of 0.001 to 0.003 square inch (64.52 x 10⁴ to 19.35 x 10⁵ µm²). For an AA size cell the first and second openings could be of a size within the range 0.002 to 0.004 square inch (12.9 x 10⁵ to 25.8 x 10⁵ µm²) and for D size cells the first and second openings could be of from 0.003 to 0.008 square inch (19.35 x 10⁴ to 51.62 x 10⁵ µm²).

In one preferred embodiment, one of the two openings disposed over the terminals of the battery is in the form of a slot or groove leading directly onto the edge of the non-conductive base film, the only proviso being that the conductive circuit must still be capable of deflection to contact the cover of the cell. In this embodiment, therefore, the size of either of the two terminal openings could exceed 0.01 square inch (64.52 x 10³ µm²). In a more preferred embodiment, it is the opening covering the second terminal, that is the cover of the battery, which is in the form of a slit or groove.

In the present invention, an expanded insulating material is deposited on the base film under the conductive circuit layer which will act as a thermal and electrical insulation for the conductive layer. The precise nature of the insulating material used is not essential to the present invention, so long as this is capable of preventing contact, either physical or electrical, between the conductive layer and the housing of the battery and of acting as a thermal barrier, except at the designated areas. The expanded insulating material has a porosity of at least 10 percent, the exact porosity being dependent on the mechanical strength of the material and the effect that this has on the handling of the material. The higher the porosity, the greater the advantages to the present invention. It is preferred that the porosity is at least 50 percent and more preferably at least 75 percent. Porosity, as used with reference to the expanded insulating material, is the percent of void volume in the material. Typically foaming ink is used as the expanded insulating material, particularly Kopack Decorative Effect UV Ink (DE Ink) obtained commercially from Kopack Company. Alternative expanded insulating materials include acrylic foams, PVC foams and polyethylene foams.

The expanded insulating material is formed on the base film as a plurality of substantially circular, elliptical, square, rectangular, triangular or any polygonal shapes or as shaped openings in a solid shape. The individual shapes or openings could be uniformly spaced apart so that the area between the individual shapes or in the openings could accommodate air which could add to the thermal insulation characteristics of the expanded material. We generally prefer that the shapes of or openings in the expanded insulating material are substantially circular and that these are spaced apart so that air can be trapped between the adjacent expanded shapes or in the openings.

The precise size of the shapes of or openings in the expanded insulating material is not essential to the present invention so long as the surface area of the expanded insulating material included in the device is sufficient to act as a thermal insulator. We have generally found that the area of the individual openings may be from 0.0001 square inch to 0.008 square inch (6.45 x 10⁴ to 51.61 x 10⁵ µm²), preferably from 0.002 to 0.006 square inch (25.8 x 10⁵ to 77.4 x 10⁵ µm²) and most preferably from 0.003 square inch to 0.005 square inch (19.35 X 10⁵ to 32.26 x 10⁵ µm²), while, generally, the area of the individual shapes may be from 0.0002 square inch to 0.01 square inch (12.9 x 10⁴ to 64.5 x 10⁵ µm²), preferably from 0.0008 square inch to 0.003 square inch (51.6 x 10⁴ to 19.35 x 10⁵ µm²).

As indicated above with relation to the openings in the non-conductive film, the exact size of the openings in or shapes of the expanded material may vary according to the size of the battery for which the tester is destined. Thus, for AAA size cells the area of the individual expanded shapes would be at the lower end of the range while the D size cells would generally be towards the higher end of the range.

The non-conductive film of the tester of the present invention may be made of any desired dielectric polymeric material, although it is preferred to use a dielectric polymeric material that will shrink when assembled on a battery. Examples of suitable polymeric materials include polyvinyl resins, polyolefin resins and polyester resins, specific examples of which include polyvinyl chloride, polyethylene and polypropylene. The precise thickness of the non-conductive film is not particularly limited and we have found that a thickness of from about 0.0005 to 0.005 inch (12.7 to 127 µm), preferably 0.001 to 0.003 inch (25.4 to 76.2 µm), is particularly suitable.

The conductive circuit layer may be formed from any material which can conduct an electrical charge. Typically, this layer may be formed from a metallic foil such as silver, nickel, iron, copper, lead, etc., and mixtures thereof or a metallized plastic layer. In the alternative, the layer may be formed from an electrically conductive polymer, or mixtures of such polymers, paints or inks, such as those that contain graphite; carbon or metals such as silver or combinations thereof which could be applied onto a substrate as the conductive layer. It is preferred that this layer is formed from silver.

The device of the present invention also includes means for indicating the capacity of the battery. The indicating means, in the form of a thermally sensitive layer, are in responsive contact with the area of controlled resistivity and will respond to and indicate the capacity of the battery. For example, a temperature will be generated in that area when a current flows through the conductive circuit layer. Thermally sensitive material will be in thermally transferable contact with the area of controlled resistivity and will indicate to the consumer the capacity of the battery. This indication can be qualitative such as a "good" reading, or quantitative such as a remaining percentage of useful life. The thermally sensitive materials would be readily viewable by a consumer. Thus the consumer, based on, for example, the colour change, can determine whether the battery is good or needs to be replaced.

Examples of suitable thermally sensitive materials include liquid crystal materials and thermochromic inks. Suitable liquid crystal materials are of the cholesteric type, such as cholesteryl oleate, cholesteryl chloride, cholesteryl caprylate and the like. Examples of suitable colour thermochromic inks include those comprised of a dye, developer and desensitizing agent, for example as disclosed in U.S. Patent No. 4,835,475. The colour indicator material could change from coloured to colourless, colourless to coloured, or one colour to a second colour.

The indicating materials, such as thermochromic inks, may be used singly or in combination. For example, in one embodiment different layers of the indicating material may be employed. The layers would be activated at different temperatures or states and can thus be designed to change to different colours at different temperatures. For example, the layer of material activated at the highest temperature will preferably be the bottom layer, and the upper layers would then suitably be arranged according to the temperature of activation such that the material with the lowest temperature of activation would form or comprise the top layer.

In the device of the present invention the conductive circuit layer may be deflected through the opening in the non-conductive layer disposed over one of both of the terminals such that a circuit is completed. However, in a preferred embodiment of the tester device of the present invention, in use, at one of the terminals the conductive circuit layer is arranged so as to be in permanent contact with the terminal, so that, in order to complete the circuit it is necessary only to deflect the conductive circuit layer through the opening in the non-conductive film at the other terminal. In one embodiment of the invention either the anode or cathode is in electrical contact with the conductive housing of the battery. In this embodiment, one of the terminal contact segments ends of the tester circuit can be permanently connected to one terminal of the housing while the other contact end is positioned out of contact with the other terminal of the housing by an opening in the base layer disposed between the housing and the segment end of the tester circuit. This opening can act as a switch for the tester circuit. By forcing the circuit contact segment end into contact with the housing through the opening, the switch is closed and the tester circuit is completed to test the battery. This contact can be conveniently made by applying finger or thumb pressure to the switch areas.

As discussed above, the testing device of this invention is suited for use as, or forming part of, the label for a battery. In such case, the label may also comprise additional insulative layers, printing layers, protective layers and the like. Suitable materials for use as the different layers are those typically used in battery labels and include plasticised or unplasticised polyvinyl chloride (UPVC), polyesters, metallic films, paper and like, and they are prepared by known methods, such as laminating the layers together. The label may be attached to the battery by the use of an adhesive. The tester label may be in the form of a single ply label or a shrinkable tube label in which a battery is encased.

A preferred tester label may include components as described in the following. A base insulative film may be adhered to the housing of the battery, which is in electrical contact with eithe rthe anode or cathode of the battery, by a suitable adhesive. The insulative film has two openings in it, as described above, for contact with the cell terminals. A separate tester circuit assembly is suitably placed on the top surface of this insulative film and one of the terminal contact segment ends of the circuit will then be aligned with one of the openings in the base film. The other terminal contact segment end of the circuit should then be aligned with the second opening such that it is in contact with and secured to the terminal of the battery (generally the cover) that is not in contact with the housing. The area of the base film onto which the tester circuit is placed has a plurality of openings as described above to function as thermal insulation means for said tester circuit. The thermal indicating material is then suitably placed over the area of controlled resistivity of the circuit. The indicating material may be placed directly on the tester circuit or it may be placed on a separate layer that is placed over the tester circuit. Preferably, the indicating material is a thermochromic ink and is in thermally transferable contract with the area of controlled resistivity. Finally a protective layer may be placed over the indicating material. The type of protective layer is selected so that the indicating material can be observed by the user. To test the strength of the battery, the user will press the label at the point above one or both openings in the insulator film to establish contact with the terminals of the battery housing. As the circuit is completed, a temperature increase will be generated in the area of controlled resistivity which will be transferred to the indicating material. If the desired temperature level is reached, the indicating material will so indicate and the user can determine the amount of capacity remaining in the battery.

In one embodiment of the invention, an outer film may be disposed over the base film containing the battery tester device and said base material and/or the outer film can contain printed and graphic design matter for the battery. A suitable material for the outer film includes polyester, polyvinyl chloride or the like.

The batteries useful in this invention are primary or secondary batteries that have positive and negative terminals. The batteries generally comprise an anode, a cathode and electrolyte contained in a sealed housing. The housing typically has an opening in one end that is sealed and closed with a cover. This cover is usually in electrical contact with either the cathode or anode to provide a terminal of the battery while the terminal of opposite polarity, generally the battery housing, is usually in electrical contact with the other electrode.

The test device label of this invention in addition to providing a label for the battery, provides a test device that is integral with the label and thereafter becomes an integral part of the battery. The test device operates such that by depressing one or two selected areas of the conductive circuit layer, the circuit is completed between the terminals of the battery via the conductive circuit layer which in turn generates heat. The heat generated is detected by the thermally sensitive material to provide a visual indication of the strength of the battery.

One particular advantage of the device of the present invention is the inclusion in the label of the expanded insulating material, particularly of the shapes of or openings in that material. These shapes and/or openings will act as a thermal insulation for the conductive layer. Thus the segment of the base film will function as a thermal and electrical insulator for the conductive circuit layer. In this arrangement, a minimum number of parts are required to produce a battery label having an integral battery tester for checking whether the battery is charged.

The present invention also provides a method for the production of a testing device, as well as a method for the attachment of such a testing device onto a battery as hereinabove described.

A preferred method for attachment of the test circuit label on the battery is in a continuous operation and involves, for example, first the preparation of a base film, such as a plastic film made with graphics and printed matter on the top side along with a first opening and a second opening and the deposited expanded insulating material. An adhesive may then be added to the bottom side of this film, which may then be attached to a suitable releasable material, such as silicone-coated release paper, to form a label carrier. In a separate operation, a circuit tester layer of the desired shape and format may then be deposited on a substrate along with a thermally sensitive material, such as thermochromic ink, An adhesive is then suitably added to the bottom surface of the substrate leaving the appropriate test circuit segment ends free of the adhesive. The side of the substrate to which the adhesive has been applied is then typically attached to releasable paper, such as silicone-coated paper, and then wound on a roll.

The resulting tester circuit roll containing the individual circuit tester devices may then be placed in a dispensing machine so as to feed the test circuit devices onto the base layer, the preparation of which is described above, in a fixed time sequence. Means can be included on the machine to detect when the area of the label containing the openings reaches a specific location, at which stage a test circuit device cut to a desired size may be dispensed without the releasable paper web and positioned over and secured to the selected area of the base label.

If desired, additional graphics could be printed on the base label and/or the test circuit layer before an outer layer is secured to the base layer. The completed base layer is cut to a desired size and then fed to another area where the silicone-coated paper web is removed and the label is secured to the housing of the battery. If desired, graphics could be placed on the outer layer of the label.

In an alternative method, the conductive material may be hot stamped onto the substrate. We prefer that the conductive circuit layer is formed as a separate part, preferably on a substrate, and shaped to have first and second segment ends that are connected to each other via an area of controlled resistivity. The first segment is suitably provided to contact a first terminal of the battery and the second segment is likewise provided to make contact with the second terminal of the battery. Thus, when the conductive circuit layer makes contact with both terminals of the battery, an electric current will flow through the area of controlled resistivity which will heat the conductive circuit layer to a range sufficient to activate the thermally sensitive material. The resistance in the area of controlled resistivity can vary to it can be constant dependent on the particular application of use.

The invention will now be further described with reference to the drawings appended hereto.

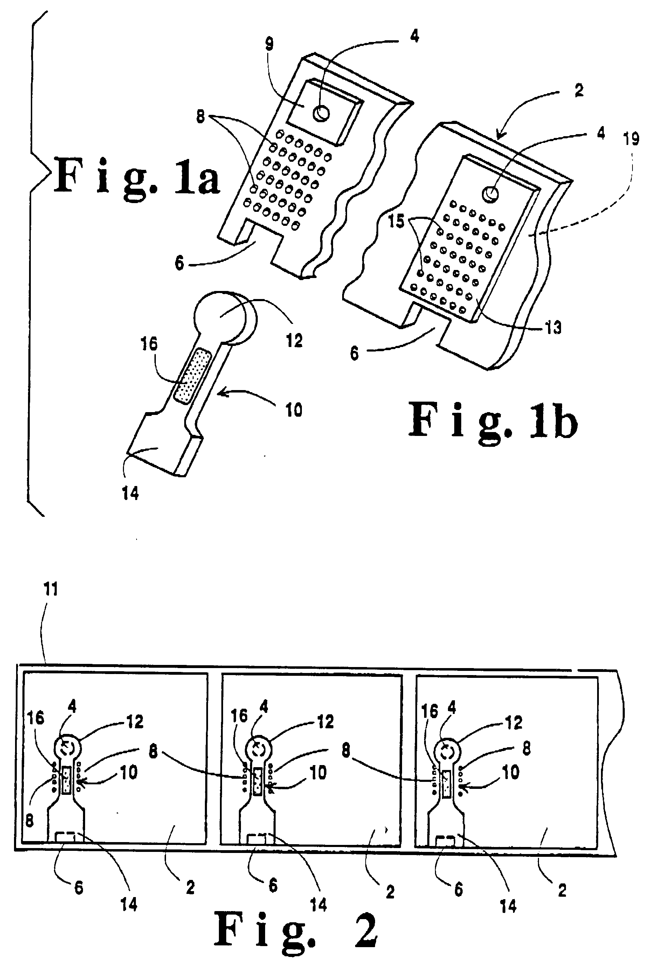

Referring to Figure 1a there is shown a base film 2 such as PVC, which has a first opening 4, a second opening 6 in the form of a slot and disposed between opening 4 and opening 6 is a plurality of circular spaced apart shapes 8 of an expanded insulating material. As stated above, the shapes could be any polygonal shapes such as circles, squares, triangles, rectangles or the like. To prevent inadvertent shorting of the test component 10 to the cell housing, an insulating material 9 is placed around opening 4. The insulating material 9 is preferably an expanded insulating material.

Shown in Figure 1b is a second embodiment of the invention in which the expanded insulating material is a solid material 13 having a plurality of openings 15. A conductive layer 10 is selectively shaped so that it can be placed over opening 4, opening 6 and at least some of the plurality of expanded shapes 8 or openings 15. Opening 4 is sufficiently large so that conductive segment layer 12 can be depressed into and through opening 4. Opening 6 is in the form of a notch so that conductive segment layer 14 can be depressed into and through notch 6 to contact a terminal of the cell. On top of conductive layer 10 is a thermally sensitive material 16 such as a thermochromic material, which will change color upon detection of a particular temperature level.

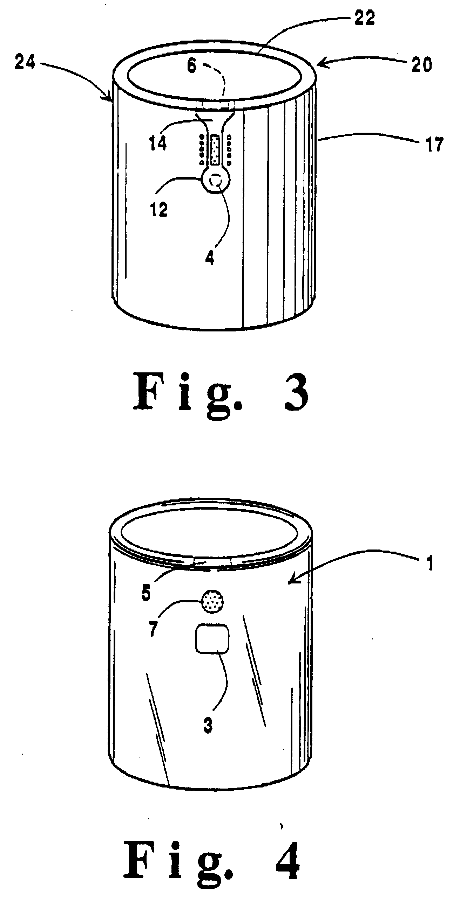

As shown in Fig. 2, conductive layer 10 is shown secured on base film 2 releasably secured to carrier layer 11, such as a silicone web, and disposed over opening 4, opening 6 and the plurality of expanded shapes 8 of the first embodiment of this invention. Disposed on top of conductive layer 10 is thermally sensitive material 16. If desired, a non-conductive film or coating (not shown) could be disposed over base film 2 thereby further securing conductive layer 10 and thermally sensitive material to base film 2. This top layer could have an adhesive side to secure to the base film 2. The non-conductive film could be in the form of a tube that could be heat shrunk onto the cell after the label is applied to the cell. Base film 2 has an adhesive layer 19 on its bottom surface (shown in Figure 1) which is secured to a battery as shown in Figure 3.

Specifically, Figure 3 shows a battery test label 17 on base film 2 (not shown) secured to the housing of battery 20. Conductive segment layer 14 can be in electrical contact with cover 22 which represents one terminal of battery 20. This conductive segment layer 14 can be permanently connected to conductive cover 22. The conductive segment layer 12 is disposed over opening 4 and is spaced apart from the cylindrical housing 24 of the battery 20 which is the second terminal of the battery 20. Thus the circuit between the two terminals of battery 20 via conductive segment layers 12 and 14 is open. To close the circuit, pressure is applied on the flexible upper layer above opening 4 in the base film. The pressure will cause the conductive segment layer 12 to make electrical contact with the battery housing 24 through opening 4. Rigidity and springback in the label will cause conductive layer 12 to break contact with housing 24 when the pressure is released. If desired, conductive segment layer 14 can also be spaced apart from the cover 22 so that to complete the circuit, pressure will have to be simultaneously applied to the flexible upper layer above both openings 4 and 6 in the base film. When the pressure is released, conductive layer segments 12 and 14 will spring back and break contact with the housing 24 and cover 22, respectively. As stated above, suitable graphics and printed matter can be placed on the base layer, conductive layer, thermally sensitive material and/or the outer layer.

As shown in Figure 4, an outer layer 1 contains designated areas 3 and 5 which correspond to the first terminal area and second terminal area, respectively, of the cell. Designated area 7 exposes an area of the thermally sensitive material so that when areas 3 and 5 are depressed, a circuit is completed and the thermally sensitive material will change color to indicate the state of charge of the cell. If desired, either area 5 or area 3 could be permanently secured to the second terminal so that only area 3 or area 5, respectively, would have to be depressed to complete the circuit.

This invention has been described in detail with particular reference to preferred embodiments thereof, but it will be understood that variations and modifications can be effected within the scope of the invention. For example, an adhesive strip could be secured over the conductive circuit layer containing the thermally sensitive material so that the conductive circuit layer could be secured to the base film using the adhesive strip.

## Claims

1. A testing device for a battery having first and second terminals, the device comprising: a non-conductive film (2) having two openings (4, 6) being so arranged that the first and second terminals of the battery are exposed therethrough; insulating means (8, 13) located between the openings; a conductive circuit layer (10) disposed on the non-conductive film (2), the conductive circuit layer (10) being disposed over the insulating means (8, 13) such that the insulating means (8, 13) provides thermal insulation for the conductive circuit layer (10), the conductive circuit layer (10) further covering the two openings in order to be able to contact the terminals of the battery therethrough; and a thermally sensitive material disposed (16) in responsive contact with the conductive circuit layer (10) such that heat produced by the flow of current through the conductive circuit layer (10) on contact of the conductive circuit layer (10) with both of the terminals results in an indication by the thermally sensitive material (16) of the charge in the battery, characterised in that the insulating means (8, 13) is an expanded insulating material having a porosity of at least 10% with a plurality of openings.

2. A device according to Claim 1 in which the conductive circuit layer (10) and the expanded insulating material (8, 13) are so arranged that that section of the conductive circuit layer (10) not disposed over the openings in the non-conductive film (2) is electrically and thermally insulated from the battery housing by the expanded insulating material (8, 13).

3. A device according to Claim 1 wherein the expanded insulating material (8, 13) is in the form of individual shapes (8), particularly selected from circles, squares, triangles and rectangles.

4. A device according to Claim 1 wherein the expanded insulating material (8, 13) is a single layer.

5. A device according to Claim 1 wherein the expanded insulating material (8, 13) is formed from a foaming ink, PVC foam, acrylic foam or polyethylene foam.

6. A device according to any one of Claims 1 to 5, in which the non-conductive film (2) is formed from a dielectric polymeric material, particularly a polyvinyl resin, polyolefin resin or polyester resin.

7. A device according to any one of Claims 1 to 6, in which the conductive circuit layer (10) is formed from a metallic foil or mixtures thereof, a metallised plastic layer, an electrically conductive polymer, or mixtures thereof, paint or ink, carbon or a metal.

8. A device according to Claim 7, in which the conductive circuit layer (10) is formed from silver, nickel, iron, copper, carbon, lead, conductive paint, conductive polymers, conductive ink or mixtures thereof

9. A device according to Claim 8, in which the conductive circuit layer (10) is formed from silver.

10. A device according to any preceding Claim, in which the thermally sensitive material (16) is a thermochromic ink or a liquid crystal material.

11. A device according to Claim 10, in which the thermally sensitive material (16) is a thermochromic ink.

12. A device according to any preceding Claim, in which, in use, the conductive circuit layer (10) is so arranged at one of the terminals to be in permanent contact with that terminal.

13. A battery having a first terminal and a second terminal of opposite polarity and including a testing device as defined in claim 1; said battery at least partially encased with a non-conductive film (2) having a top surface and bottom surface and said film (2) defining a first opening (4) exposing a segment of the first terminal and a spaced apart second opening (6) exposing a segment of the second terminal; and insulating means (8, 13) disposed between said first opening (4) and said second opening (6); a conductive circuit layer (10) disposed over the first opening (4), the second opening (6), and at least a portion of the insulating means (8, 13) so that a first segment (12) of conductive circuit layer (10) can be deflected through the first opening (4) to contact the first terminal, a second segment (14) of the conductive circuit layer (10) can be deflected through the second opening (6) to contact the second terminal with the remaining segment of the conductive circuit layer (10) being electrically and thermally insulated from the terminals of the battery by the insulating means (8, 13); a thermally sensitive material (16) disposed in responsive contact with the conductive circuit layer (10) such that when the first segment (12) and second segment (14) of the conductive circuit layer (10) contact the first terminal and second terminal, respectively, a current will flow through the conductive circuit layer (10) and heat the thermally sensitive material (16) which will indicate the capacity of the battery, characterised in that the insulating means (8, 13) is an expanded insulating material having a porosity of at least 10% with a plurality of openings.

14. A battery including a device according to any one of the preceding Claims 1 to 12.

15. A battery according to Claim 13 or Claim 14, in which the device forms all or part of the label.

16. A battery according to Claim 15 further including a film heat shrunk over at least the testing device.

17. A battery according to any one of Claims 13 to 16 comprising a housing (24) composed of a cylindrical container closed at one end and open at the opposite end, said container forming the first terminal of the battery; and a cover (22) secured over and electrically insulated from the open end of the container, said cover (22) forming the second terminal of the battery.

18. A method for preparing and attaching a battery testing device as defined in claim 1 to a battery comprising the steps:
(a) preparing a non-conductive base film (2) having a top surface and a bottom surface and producing in said film (2) a first opening (4) and a spaced apart second opening (6); and depositing an insulating means (8, 13) on said base film (2) between said first opening (4) and said second opening (6);
(b) securing a thermally sensitive material (16) to the top surface of a conductive circuit layer (10) and securing the bottom surface of the conductive circuit layer (10) onto the top surface of the base film (13) and over the first opening (4), the second opening (6) and at least a portion of the insulating means (8, 13) such that a first segment (12) of the conductive circuit layer (10) can deflect into and through said first opening (4), the insulating means (8, 13) providing electrical and thermal insulation for at least a portion of the remaining conductive circuit layer (10) between the first opening (4) and second opening (6);
(c) adhering the bottom surface of the base film (2) to the housing of a battery having a first terminal and second terminal of opposite polarity such that the first opening (4) is positioned over the first terminal and the second opening (6) is positioned over the second terminal so that said first segment (12) can be deflected to contact only the first terminal and the second terminal contacts or is contactible with a second segment (14) of the conductive circuit layer (10)through the second opening (6) to complete an electrical circuit between the terminals that allows current to flow through the conductive circuit layer (10) to create heat detectable by the thermally sensitive material (16),
characterised in that the insulating means (8, 13) is a single layer of an expanded insulating material having a porosity of at least 10% with a plurality of openings.

19. A method according claim 18 wherein in step (a) the base film (2) has an adhesive layer (19) on its bottom surface and a releasable film disposed over the adhesive layer (19) and in step (c) the releasable film is removed and the bottom surface of the base film (2) is secured to the housing of the battery using the adhesive layer (19).

20. A method according to claim 18 wherein in step (b) the bottom surface of the conductive circuit layer (10) has an adhesive layer with the first segment (12) of the conductive circuit layer (10) and the second segment (14) of the conductive circuit layer (10) free of said adhesive, and a releasable film disposed over the adhesive layer, and the releasable film is removed prior to securing the conductive circuit layer (10) to the base film (2) using the adhesive layer.

21. A method according to claim 18 wherein the following step is added:
(d) securing a non-conductive film over the base film (2) containing the conductive circuit layer (10) and the thermally sensitive material (16).

## Patentansprüche

1. Prüfgerät für eine Batterie mit einem ersten und einem zweiten Pol, wobei das Gerät die folgenden Elemente enthält: einen nichtleitenden Film (2), mit zwei Öffnungen (4, 6), die so eingerichtet sind, dass der erste und der zweite Pol der Batterie durch dieselben hindurch freiliegend sind; Isolationsmittel (8, 13), die zwischen den Öffnungen gelegen sind; eine leitfähige Stromkreisschicht (10), die auf dem nichtleitenden Film (2) angeordnet ist, wobei die leitfähige Stromkreisschicht (10) über den Isolationsmitteln (8, 13) so angeordnet wird, dass die Isolationsmittel (8, 13) eine thermische Isolierung für die leitfähige Stromkreisschicht (10) liefern, wobei die leitfähige Stromkreisschicht (10) ferner die zwei Öffnungen bedeckt, um in der Lage zu sein durch dieselben hindurch mit den Polen der Batterie in Berührung zu stehen; und ein thermisch empfindliches Material (16), das in einem ansprechenden Kontakt mit der leitfähigen Stromkreisschicht (10) angeordnet ist, so dass die Wärme, die infolge des Kontaktes der leitfähigen Stromkreisschicht (10) mit den beiden Polen durch das Fließen des Stromes durch die leitfähige Stromkreisschicht (10) erzeugt wird, zu einer Anzeige der Aufladung der Batterie durch das thermisch empfindliche Material (16) führt, dadurch gekennzeichnet, dass die Isolationsmittel (8, 13) aus einem expandierten Isolationsmaterial mit einer Porosität von mindestens 10 % mit einer großen Anzahl von Öffnungen bestehen.

2. Gerät gemäß Anspruch 1, in welchem die leitfähige Stromkreisschicht (10) und das expandierte Isolationsmaterial (8, 13) so angeordnet sind, dass derjenige Abschnitt der leitfähigen Stromkreisschicht (10), der nicht über den Öffnungen in dem nichtleitenden Film (2) angeordnet ist, elektrisch und thermisch durch das expandierte Isolationsmaterial (8, 13) von dem Batteriegehäuse isoliert wird.

3. Gerät gemäß Anspruch 1, in welchem das expandierte Isolationsmaterial (8, 13) unter der Gestalt von einzelnen Formen (8) vorliegt, welche insbesondere ausgewählt werden unter Kreisen, Quadraten, Dreiecken und Rechtecken.

4. Gerät gemäß Anspruch 1, in welchem das expandierte Isolationsmaterial (8, 13) in einer einzelnen Schicht vorliegt.

5. Gerät gemäß Anspruch 1, in welchem das expandierte Isolationsmaterial (8, 13) aus einer schäumenden Tinte, einem PVC-Schaum, einem Acrylschaum oder einem Polyethylenschaum gebildet wird.

6. Gerät gemäß irgendeinem der Ansprüche 1 bis 5, in welchem der nichtleitende Film (2) aus einem dielektrischen polymeren Material gebildet wird, insbesondere aus einem Polyvinylharz, einem Polyolefinharz oder einem Polyesterharz.

7. Gerät gemäß irgendeinem der Ansprüche 1 bis 6, in welchem die leitfähige Stromkreisschicht (10) gebildet wird aus einer metallischen Folie oder Mischungen derselben, aus einer metallisierten Plastikschicht, einem elektrisch leitfähigen Polymer oder Mischungen derselben, aus Farbe oder Tinte, aus Kohlenstoff oder einem Metall.

8. Gerät gemäß Anspruch 7, in welchem die leitfähige Stromkreisschicht (10) gebildet wird aus Silber, Nickel, Eisen, Kupfer, Kohlenstoff, Blei, leitfähiger Farbe, leitfähigen Polymeren, leitfähiger Tinte oder Mischungen derselben.

9. Gerät gemäß Anspruch 8, in welchem die leitfähige Stromkreisschicht (10) aus Silber gebildet wird.

10. Gerät gemäß irgendeinem der vorhergehenden Ansprüche, in welchem das thermisch empfindliche Material (16) eine thermochromische Tinte oder ein Flüssigkristallmaterial ist.

11. Gerät gemäß Anspruch 10, in welchem das thermisch empfindliche Material (16) eine thermochromische Tinte ist.

12. Gerät gemäß irgendeinem der vorhergehenden Ansprüche, in welchem, während des Gebrauchs, die leitfähige Stromkreisschicht (10) an einem der Pole so eingerichtet ist, dass sie in permanentem Kontakt mit diesem Pol steht.

13. Batterie, die einen ersten Pol und einen zweiten Pol von entgegengesetzter Polarität aufweist und welche ein Prüfgerät umfasst wie es in Anspruch 1 definiert worden ist; wobei die besagte, mindestens teilweise von einem nichtleitenden Film (2) ummantelte Batterie eine obere Oberfläche und eine untere Oberfläche aufweist und wobei der besagte Film (2) eine erste Öffnung (4) begrenzt, die einen Abschnitt des ersten Pols freilegt, sowie eine zweite mit Abstand angeordnete Öffnung (6) begrenzt, die einen Abschnitt des zweiten Pols freilegt; und Isoliermittel (8, 13), die zwischen der ersten Öffnung (4) und der zweiten Öffnung (6) angeordnet sind; eine leitfähige Stromkreisschicht (10), die über die erste Öffnung (4), die zweite Öffnung (6) und mindestens einen Teil der Isolationsmittel (8, 13) angeordnet ist, so dass ein erster Abschnitt (12) der leitfähigen Stromkreisschicht (10) durch die erste Öffhung (4) abgebogen werden kann, um mit dem ersten Pol in Berührung zu treten, ein zweiter Abschnitt (14) der leitfähigen Stromkreisschicht (10) durch die zweite Öffnung (6) abgebogen werden kann, um den zweiten Pol in Berührung zu setzen mit dem verbleibenden Abschnitt der leitfähigen Stromkreisschicht (10), die elektrisch und thermisch durch die Isolationsmittel (8, 13) von den Polen der Batterie isoliert ist; ein thermisch empfindliches Material (16), das in einem ansprechenden Kontakt mit der leitfähigen Stromkreisschicht (10) angeordnet ist, so dass, wenn der erste Abschnitt (12) und der zweite Abschnitt (14) der leitfähigen Stromkreisschicht (10) mit dem ersten Pol beziehungsweise mit dem zweiten Pol in Berührung stehen, ein Strom durch die leitfähige Stromkreisschicht (10) fließen wird und das thermisch empfindliche Material (16) aufwärmen wird, welches die Leistungsfähigkeit der Batterie anzeigt, dadurch gekennzeichnet, dass die Isolationsmittel (8, 13) aus einem expandierten Isolationsmaterial mit einer Porosität von mindestens 10% mit einer großen Zahl von Öffhungen bestehen.

14. Batterie, die ein Gerät gemäß irgendeinem der vorhergehenden Ansprüche 1 bis 12 enthält

15. Batterie gemäß Anspruch 13 oder Anspruch 14, in welchem das Gerät das ganze Etikett oder einen Teil desselben darstellt.

16. Batterie gemäß Anspruch 15, welche ferner einen durch Wärme über mindestens das Prüfgerät aufgeschrumpften Film enthält.

17. Batterie gemäß irgendeinem der Ansprüche 13 bis 16, welche ein Gehäuse (24) enthält, das aus einem zylindrischen Behälter zusammengestellt wird, welcher an einem Ende geschlossen ist und an dem entgegengesetzten Ende offen ist, wobei der besagte Behälter den ersten Pol der Batterie bildet; und einen Deckel (22), der über das offene Ende des Behälters befestigt wird und von demselben elektrisch isoliert ist, wobei der besagte Deckel (22) den zweiten Pol der Batterie bildet.

18. Verfahren zur Erzeugung eines Batterieprüfgerätes, wie es in Anspruch 1 definiert worden ist, sowie Befestigung desselben an eine Batterie, wobei die nachfolgenden Schritte impliziert sind:
(a) Zubereitung eines nichtleitenden Grundfilms (2) mit einer oberen Oberfläche und einer unteren Oberfläche und Erzeugung in dem besagten Film (2) einer ersten Öffnung (4) und einer zweiten mit Abstand angeordneten Öffnung (6); und Ablagern von Isolationsmitteln (8, 13) auf diesem Grundfilm (2) zwischen der ersten Öffnung (4) und der zweiten Öffnung (6);
(b) Befestigung eines thermisch empfindlichen Materials (16) auf der oberen Oberfläche einer leitfähigen Stromkreisschicht (10) und Befestigung der unteren Oberfläche der leitfähigen Stromkreisschicht (10) auf die obere Oberfläche des Grundfilms (2) und über die erste Öffnung (4), die zweite Öffnung (6) und mindestens einen Teil der Isolationsmittel (8, 13), so dass ein erster Abschnitt (12) der leitfähigen Stromkreisschicht (10) in und durch die erste Öffnung (4) abgebogen werden kann, wobei die Isolationsmittel (8, 13) eine elektrische und thermische Isolierung für mindestens einen Abschnitt der verbleibenden leitfähigen Stromkreisschicht (10) zwischen der ersten Öffnung (4) und der zweiten Öffnung (6) besorgen;
(c) Anhaften der unteren Oberfläche des Grundfilmes (2) an das Batteriegehäuse mit einem ersten Pol und einem zweiten Pol von entgegengesetzter Polarität, so dass die erste Öffnung (4) über dem ersten Pol lokalisiert ist und die zweite Öffnung (6) über dem zweiten Pol lokalisiert ist, so dass der erste Abschnitt (12) abgebogen werden kann, um lediglich mit dem ersten Pol in Berührung gebracht zu werden und der zweite Pol steht in Berührung oder kann in Berührung gebracht werden mit einem zweiten Abschnitt (14) der leitfähigen Stromkreisschicht (10) durch die zweite Öffnung (6) hindurch, um einen elektrischen Stromkreis zwischen den Polen zu vervollständigen, welcher es dem Strom erlaubt durch die leitfähige Stromkreisschicht (10) zu fließen, um Wärme zu erzeugen, welche durch das thermisch empfindliche Material (16) festgestellt werden kann,
dadurch gekennzeichnet, dass die Isolationsmittel (8, 13) aus einer einzelnen Schicht eines expandierten Isolationsmaterial mit einer Porosität von mindestens 10 % mit einer großen Anzahl von Öffnungen bestehen.

19. Verfahren gemäß Anspruch 18, in welchem bei dem Schritt (a) der Grundfilm (2) eine Haftschicht (19) auf seiner unteren Oberfläche besitzt sowie einen abtrennbaren Film, der über der Haftschicht (19) angeordnet ist und in welchem bei dem Schrift (c) der abtrennbare Film entfernt wird und die untere Oberfläche des Grundfilms (2) an dem Batteriegehäuse mit Hilfe der Haftschicht (19) befestigt wird.

20. Verfahren gemäß Anspruch 18, in welchem bei dem Schritt (b) die untere Oberfläche der leitfähigen Stromkreisschicht (10) eine Haftschicht mit dem ersten Abschnitt (12) der leitfähigen Stromkreisschicht (10) besitzt und der zweite Abschnitt (14) der leitfähigen Stromkreisschicht (10) frei von dem besagen Haftmittel ist, und ein abtrennbarer Film über der Haftschicht angeordnet ist, und der abtrennbare Film entfernt wird vor der Befestigung der leitfähigen Stromkreisschicht (10) mit Hilfe der Haftschicht an dem Grundfilm (2).

21. Verfahren gemäß Anspruch 18, in welchem der folgende Schritt hinzugefügt wird:
(d) Befestigung eines nichtleitenden Films über dem Grundfilm (2), welcher die leitfähige Stromkreisschicht (10) und das thermisch empfindliche Material (16) enthält.

## Revendications

1. Dispositif de contrôle pour une batterie présentant une première et une deuxième bornes, le dispositif comprenant: un film non conducteur (2) avec deux ouvertures (4, 6) qui sont agencées de manière à ce que la première et la deuxième bornes de la batterie sont exposées à travers celles-ci; des moyens isolants (8, 13) situés entre les ouvertures; une couche de circuit conductrice (10) disposée sur le film non conducteur (2), la couche de circuit conductrice (10) étant disposée au-dessus des moyens isolants (8, 13) de sorte que les moyens isolants (8,13) fournissent une isolation thermique pour la couche de circuit conductrice (10), la couche de circuit conductrice (10) recouvrant en outre les deux ouvertures dans le but d'être capable d'établir un contact avec les bornes de la batterie à travers celles-ci; et un matériau thermosensible (16) disposé en contact sensible avec la couche de circuit conductrice (10) de sorte que la chaleur produite par le flux de courant à travers la couche de circuit conductrice (10) lors d'un contact de la couche de circuit conductrice (10) avec les deux bornes conduit à une indication par le matériau thermosensible (16) de la charge dans la batterie, caractérisé en ce que les moyens isolants (8, 13) sont constitués d'un matériau isolant expansé présentant une porosité d'au moins 10 % avec une pluralité d'ouvertures.

2. Dispositif suivant la revendication 1, dans lequel la couche de circuit conductrice (10) et le matériau isolant expansé (8, 13) sont agencés de manière à ce que cette section de la couche de circuit conductrice (10) qui n'est pas disposée au-dessus des ouvertures dans le film non conducteur (2) est isolée électriquement et thermiquement de l'habitacle de la batterie par le matériau isolant expansé (8, 13).

3. Dispositif suivant la revendication 1, dans lequel le matériau isolant expansé (8, 13) se trouve sous la forme de formes individuelles (8), choisies en particulier à partir de cercles, de carrés, de triangles et de rectangles.

4. Dispositif suivant la revendication 1, dans lequel le matériau isolant expansé (8, 13) est une couche unique.

5. Dispositif suivant la revendication 1, dans lequel le matériau isolant expansé (8, 13) est formé à partir d'une encre moussante, d'une mousse PVC, d'une mousse acrylique ou d'une mousse de polyéthylène.

6. Dispositif suivant l'une quelconque des revendications 1 à 5, dans lequel le film non conducteur (2) est formé à partir d'un matériau polymère diélectrique, en particulier d'une résine de polyvinyle, d'une résine de polyoléfine ou d'une résine de polyester.

7. Dispositif suivant l'une quelconque des revendications 1 à 6, dans lequel la couche de circuit conductrice (10) est formée à partir d'une feuille métallique ou de mélanges de celles-ci, d'une couche de plastique métallisée, d'un polymère électriquement conducteur, ou de mélanges de ceux-ci, d'une peintre ou d'une encre, de carbone ou d'un métal.

8. Dispositif suivant la revendication 7, dans lequel la couche de circuit conductrice (10) est formée à partir d'argent, de nickel, de fer, de cuivre, de carbone, de plomb, d'une peintre conductrice, de polymères conducteurs, d'une encre conductrice ou de mélanges de ceux-ci.

9. Dispositif suivant la revendication 8, dans lequel la couche de circuit conductrice (10) est formée à partir d'argent.

10. Dispositif suivant l'une quelconque des revendications précédentes, dans lequel le matériau thermosensible (16) est une encre thermochromique ou un matériau à base de cristaux liquides.

11. Dispositif suivant la revendications 10, dans lequel le matériau thermosensible (16) est une encre thermochromique.

12. Dispositif suivant l'une quelconque des revendications précédentes, dans lequel, à l'usage, la couche de circuit conductrice (10) est installée de cette manière au niveau d'une des bornes pour être en contact permanent avec cette borne.

13. Batterie présentant une première borne et une deuxième borne de polarités opposées et incluant un dispositif de contrôle comme il est défini dans la revendication 1; ladite batterie au moins partiellement enveloppée avec un film non conducteur (2) possédant une surface supérieure et une surface inférieure et ledit film (2) définissant une première ouverture (4) exposant un segment de la première borne et une deuxième ouverture (6) espacée exposant un segment de la deuxième borne; et des moyens isolants (8, 13) disposés entre ladite première ouverture (4) et ladite deuxième ouverture (6); une couche de circuit conductrice (10) disposée au-dessus de la première ouverture (4), la deuxième ouverture (6) et au moins une partie des moyens isolants (8, 13) de sorte qu'un premier segment (12) de la couche de circuit conductrice (10) peut être dévié à travers la première ouverture (4) pour établir un contact avec la première borne, un deuxième segment (14) de la couche de circuit conductrice (10) peut être dévié à travers la deuxième ouverture (6) pour établir un contact avec la deuxième borne, le segment restant de la couche de circuit conductrice (10) étant isolé électriquement et thermiquement des bornes de la batterie par les moyens isolants (8, 13); un matériau thermosensible (16) disposé en contact sensible avec la couche de circuit conductrice (10) de sorte que lorsque le premier segment (12) et le deuxième segment (14) de la couche de circuit conductrice (10) établissent un contact avec la première borne et la deuxième borne, respectivement, un courant va circuler à travers la couche de circuit conductrice (10) et chauffer le matériau thermosensible (16), ce qui indiquera la capacité de la batterie, caractérisée en ce que les moyens isolants (8, 13) sont constitués d'un matériau isolant expansé présentant une porosité d'au moins 10 % avec une pluralité d'ouvertures.

14. Batterie incluant un dispositif suivant l'une quelconque des revendications 1 à 12 précédentes.

15. Batterie suivant la revendication 13 ou la revendication 14, dans laquelle le dispositif constitue la totalité ou une partie de l'étiquette.

16. Batterie suivant la revendication 15, incluant en outre un film rétréci à la chaleur au-dessus d'au moins le dispositif de contrôle.

17. Batterie suivant l'une quelconque des revendications 13 à 16, comprenant un habitacle (24) composé d'un conteneur circulaire fermé au niveau d'une extrémité et ouvert au niveau de l'extrémité opposée, ledit conteneur formant la première borne de la batterie; et d'une enveloppe (22) fixée au-dessus et isolée électriquement de l'extrémité ouverte du conteneur, ladite enveloppe (22) formant la deuxième borne de la batterie.

18. Procédé pour la préparation et la fixation d'un dispositif de contrôle de batterie comme il est défini dans la revendication 1 sur une batterie comprenant les étapes:
(a) de préparation d'un film de base non conducteur (2) possédant une surface supérieure et une surface inférieure et de production dans ledit film (2) d'une première ouverture (4) et d'une deuxième ouverture (6) espacée; et de dépôt de moyens isolants (8, 13) sur ledit film de base (2) entre ladite première ouverture (4) et ladite deuxième ouverture (6);
(b) de fixation d'un matériau thermosensible (16) sur la surface supérieure d'une couche de circuit conductrice (10) et de fixation de la surface inférieure de la couche de circuit conductrice (10) sur la surface supérieure du film de base (2) et au-dessus de la première ouverture (4), la deuxième ouverture (6) et au moins une partie des moyens isolants (8, 13) de sorte qu'un premier segment (12) de la couche de circuit conductrice (10) peut dévier dans et à travers ladite première ouverture (4), les moyens isolants (8, 13) fournissant une isolation électrique et thermique pour au moins une partie de la couche de circuit conductrice (10) restante entre la première ouverture (4) et la deuxième ouverture (6);
(c) d^{'}adhésion de la surface inférieure du film de base (2) sur l'habitacle d'une batterie avec une première borne et une deuxième borne de polarités opposées de sorte que la première ouverture (4) est positionnée au-dessus de la première borne et la deuxième ouverture (6) est positionnée au-dessus de la deuxième borne de manière à ce que ledit premier segment (12) peut être dévié pour établir un contact seulement avec la première borne et la deuxième borne établit un contact ou est susceptible d'établir un contact avec un deuxième segment (14) de la couche de circuit conductrice (10) à travers la deuxième ouverture (6) afin de fermer un circuit électrique entre les bornes ce qui permet à un courant de circuler à travers la couche de circuit conductrice (10) pour créer de la chaleur détectable par le matériau thermosensible (16),
caractérisé en ce que les moyens isolants (8, 13) sont constitués d'une seule couche d'un matériau isolant expansé présentant une porosité d'au moins 10 % avec une pluralité d'ouvertures.

19. Procédé suivant la revendication 18, dans lequel dans l'étape (a) le film de base (2) possède une couche adhésive (19) sur sa surface inférieure et un film détachable disposé au-dessus de la couche adhésive (19) et dans l'étape (c) le film détachable est retiré et la surface inférieure du film de base (2) est fixée sur l'habitacle de la batterie en mettant en oeuvre la couche adhésive (19).

20. Procédé suivant la revendication 18, dans lequel dans l'étape (b) la surface inférieure de la couche de circuit conductrice (10) possède une couche adhésive avec le premier segment (12) de la couche de circuit conductrice (10) et le deuxième segment (14) de la couche de circuit conductrice (10) exempts dudit adhésif, et un film détachable disposé au-dessus de la couche adhésive, et le film détachable est retiré avant de fixer la couche de circuit conductrice (10) sur le film de base (2) en mettant en oeuvre la couche adhésive.

21. Procédé suivant la revendication 18, dans lequel l'étape suivante est ajoutée:
(d) fixation d'un film non conducteur au-dessus du film de base (2) contenant la couche de circuit conductrice (10) et le matériau thermosensible (16).
